# EUROPÄISCHE PATENTSCHRIFT

(11) **EP 0 740 082 B1**
(45) Veröffentlichungstag und Bekanntmachung des Hinweises auf die Patenterteilung: **16.08.2000**
(21) Anmeldenummer: 96106421.9
(22) Anmeldetag: 24.04.1996
(51) Int. Cl.: F15B 13/00

(54) **Modularer elektrischer Teil für einen Ventilblock**
Modular electrical part for a valve block
Dispositif électrique modulaire pour un assemblage de bloc de vannes

(30) Priorität: 27.04.1995 DE 29507119 U
(43) Veröffentlichungstag der Anmeldung: 30.10.1996
(73) Patentinhaber: Bürkert Werke GmbH & Co., D-74653 Ingelfingen (DE)
(72) Erfinder: Rohrbeck, Heribert, 74523 Schwäbisch Hall (DE); Ottliczky, Martin, 74670 Forchtenberg (DE)
(74) Vertreter: Degwert, Hartmut, Dipl.-Phys.

(56) Entgegenhaltungen:
- EP-A- 0 606 048
- CH-A- 683 021
- DE-A- 4 343 958
- DE-U- 9 406 393
- GB-A- 2 263 154

## Beschreibung

Die Erfindung betrifft einen modularen elektrischen Teil zur zentralen Versorgung und/oder Ansteuerung von einem Ventilblock zugeordneten Ventilen. Ein Solcher Teil ist aus der CH-A-683 021 bekannt.

Es sind bereits modular aufgebaute Ventilblöcke bekannt. Diese weisen jedoch insbesondere den Nachteil auf, daß für verschiedene Anwendungen, Ventilgrößen und Ventilanordnungen eine Vielzahl unterschiedlicher Komponenten bereitzustellen ist. So muß beispielsweise ein jeweiliger Ventilblock stets für eine ganz bestimmte Ventilgröße konzipiert werden. Im Ergebnis führt dies zu einer kostenintensiven Produktion und Lagerhaltung.

Ziel der Erfindung ist es, einen modularen elektrischen Teil der eingangs genannten Art zu schaffen, der aus wenigen elementaren Komponenten zusammengesetzt und dadurch problemlos an unterschiedliche Anforderungen wie insbesondere eine sich ändernde Anzahl von anzuschließenden Ventilen und/oder ein Anschluß von Ventilen unterschiedlicher Art angepaßt werden kann.

Die Aufgabe wird nach der Erfindung dadurch gelöst, daß der modulare elektrische Teil wenigstens einen Grundmodul enthält, der ein an zwei gegenüberliegenden Stirnseiten offenes Gehäuse besitzt, in das eine Leiterplatte mit einem oder mehreren Anschlußkontakten eingesetzt ist, wobei eine Gehäuseseitenwandung mit wenigstens einem Durchbruch versehen ist, durch den hindurch ein betreffendes Ventil oder irgendein anderer Aktor an wenigstens einen zugeordneten Anschlußkontakt anschließbar ist, und wenigstens einen der zentralen Versorgung und/oder Ansteuerung dienenden Anschlußmodul sowie wenigstens einen Blindabschlußmodul enthält, und daß die Module eine gleichartige Querschnittsform besitzen, bedarfsweise unter Herstellung von jeweiligen elektrischen Zwischenverbindungen bzw. eines stirnseitigen Blindabschlusses aneinanderreihbar und lösbar miteinander verbindbar sind.

Aufgrund dieser Ausbildung kann der elektrische Teil ausgehend von einer minimierten Anzahl standardisierter Module zur Schaffung eines an die jeweilige Anwendung optimal angepaßten Systems auf einfache Weise zusammengesetzt werden. Die Anzahl unterschiedlicher Module beschränkt sich auf einen elektrischen Grundmodul, einen elektrischen Anschlußmodul und auf je einen Blindabschlußmodul für das eine bzw. das andere Ende einer jeweiligen Modulreihe. Bedarfsweise können mehrere Grundmodule aneinandergereiht werden, wobei die Anzahl der aneinandergereihten Grundmodule allenfalls durch die Ansteuerung begrenzt ist.

Je nach Anwendung können die Grundmodule mit einer unterschiedlichen Anzahl von Anschlußkontakten und zugeordneten Durchbrüchen und/oder mit Durchbrüchen unterschiedlicher Anzahl und/oder Größe vorgesehen sein. Diese Durchbrüche können auf einfache Weise in die betreffenden Grundmodule gestanzt sein.

Der Grundmodul kann vorteilhafterweise auch freie elektrische Ausgänge aufweisen, die wiederum über einen Anschlußmodul versorgt und/oder angesteuert werden. Diese freien Ausgänge können für beliebige Anwendungen wie z. B. den Anschluß einer Hupe oder dergleichen herangezogen werden.

Gemäß einer besonders vorteilhaften Ausführungsform enthält der modulare elektrische Teil wenigstens einen bedarfsweise auf einen jeweiligen Grundmodul aufsetzbaren, lösbar mit diesem verbindbaren Rückmeldemodul, der die Ventile betreffende Rückmeldesignale liefert. Nachdem somit die Grund- und Rückmeldemodule nicht mehr als Einheit sondern getrennt ausgebildet sind, können die Rückmeldemodule bedarfsweise eingesetzt oder weggelassen werden, wobei im zweiten Fall zusätzlich der Platzbedarf verringert wird. Für Regelungen, bei denen eine Rückmeldung des Ist-Zustandes durch Sensoren erforderlich ist, kann der Ventilblock durch solche Rückmeldemodule erweitert werden, die den Ventilen gezielt zugeordnet werden, die die Sensorik enthalten.

Der elektrische Anschlußmodul kann hinsichtlich seiner Art je nach Anwendung gewählt werden und beispielsweise durch einen Null- und Schutzleiteranschlüsse aufweisenden Anschlußmodul, als mehrpoliger Stecker oder auch als einem Feldbusmodul zugeordneter Anschlußmodul ausgebildet sein. Im Fall des Anschlusses eines Multipolmoduls mit mehrpoligem Stecker kann eine 1:1-Verdrahtung vorgesehen sein. Dagegen kann bei höheren Anforderungen an die Ansteuerung ein Feldbusmodul angeschlossen werden. Grundsätzlich können jedoch auch weitere Module insbesondere für freie Eingänge, freie Ausgänge, Kleinsteuerungen oder ein speicherprogrammiertes System (SPS) integriert werden.

Der erfindungsgemäße elektrische Teil ist problemlos insbesondere auch für den Fall eines Anschlusses von Impulsventilen geeignet, die für ihre Funktion zwei elektrische Eingänge benötigen. In diesem Fall ist zweckmäßigerweise vorgesehen, daß einem Durchbruch für den Anschluß eines solchen Impulsventils oder dergleichen jeweils zwei Anschlußkontakte gegenüberliegen.

Aufgrund der im Anspruch 18 angegebenen erfindungsgemäßen Ausbildung der Leiterplatten können die Grund- und/oder Rückmeldemodule bedarfsweise ohne weiteres gegen andere Module ausgetauscht werden, das beispielsweise für eine unterschiedliche Anzahl von Ventilen oder unterschiedliche Ventilgrößen ausgelegt ist. Durch die angegebene Leiterbahnführung ist sichergestellt, daß die geforderte Reihenfolge der Anschlüsse stets eingehalten wird.

Erfindungsgemäß können die Module somit durch einfaches Zusammenstecken miteinander verbunden und bedarfsweise problemlos wieder voneinander getrennt werden. Dies ermöglicht ein einfaches und schnelles Auswechseln der Module, wodurch dem Umstand Rechnung getragen wird, daß Fehler vor allem im elektrischen Teil des Ventilblocks entstehen. Im Störungsfall kann dann ein betreffender Modul auf einfache und schnelle Weise durch einen anderen ersetzt werden.

Nachdem der elektrische Anschluß des Ventilblocks austauschbar ist, kann dessen Anschlußart auch zu einem späteren Zeitpunkt noch geändert werden.

In den Unteransprüchen sind weitere vorteilhafte Ausführungsvarianten der Erfindung angegeben.

Die Erfindung wird im folgenden anhand von Ausführungsbeispielen unter Bezugnahme auf die Zeichnung näher erläutert; in dieser zeigen:
- Fig. 1: eine schematische auseinandergezogene Darstellung eines elektrischen Teils eine Ventilblocks mit drei elektrischen Grundmodulen, einem elektrischen Anschlußmodul und einem Blindabschlußmodul,
- Fig. 2: eine schematische auseinandergezogene Darstellung eines elektrischen Teils eines Ventilblocks mit einem zusätzlichen Rückmeldemodul, dem wiederum ein elektrischer Anschlußmodul sowie ein Blindabschlußmodul zugeordnet sind,
- Fig. 3: eine schematische auseinandergezogene Darstellung eines elektrischen Teils eines Ventilblocks mit einem an die Grundmodulreihe anschließbaren Feldbusmodul, und
- Fig. 4: eine schematische Darstellung zur Erläuterung des Prinzips des Leiterbahnverlaufs auf den verschiedenen Leiterplatten.

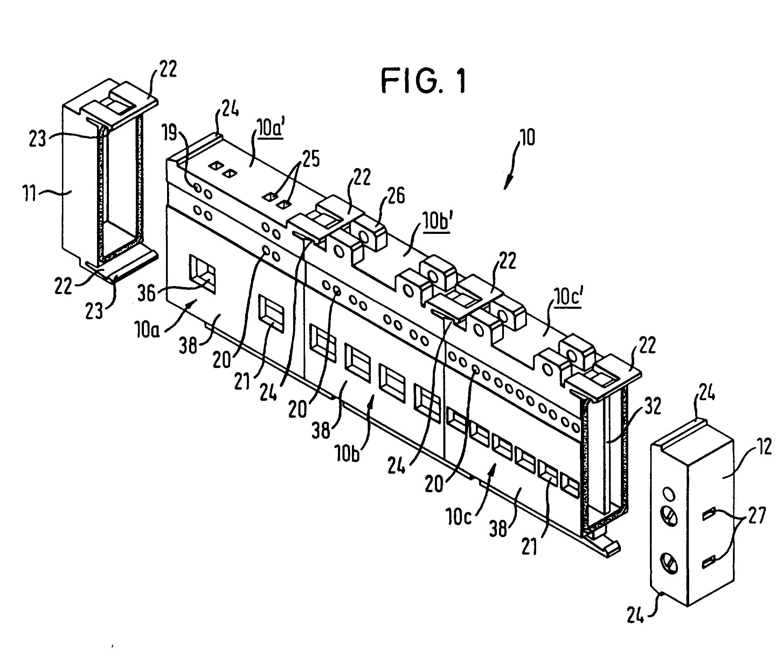

Die Figuren 1 bis 3 zeigen Ausführungsformen eines modularen elektrischen Teils 10 eines darüber hinaus nicht dargestellten, die Ventile mit den Ventilantrieben und eine pneumatische Grundschiene zur Zu- und Abfuhr eines Druckmittels umfassenden Ventilblocks.

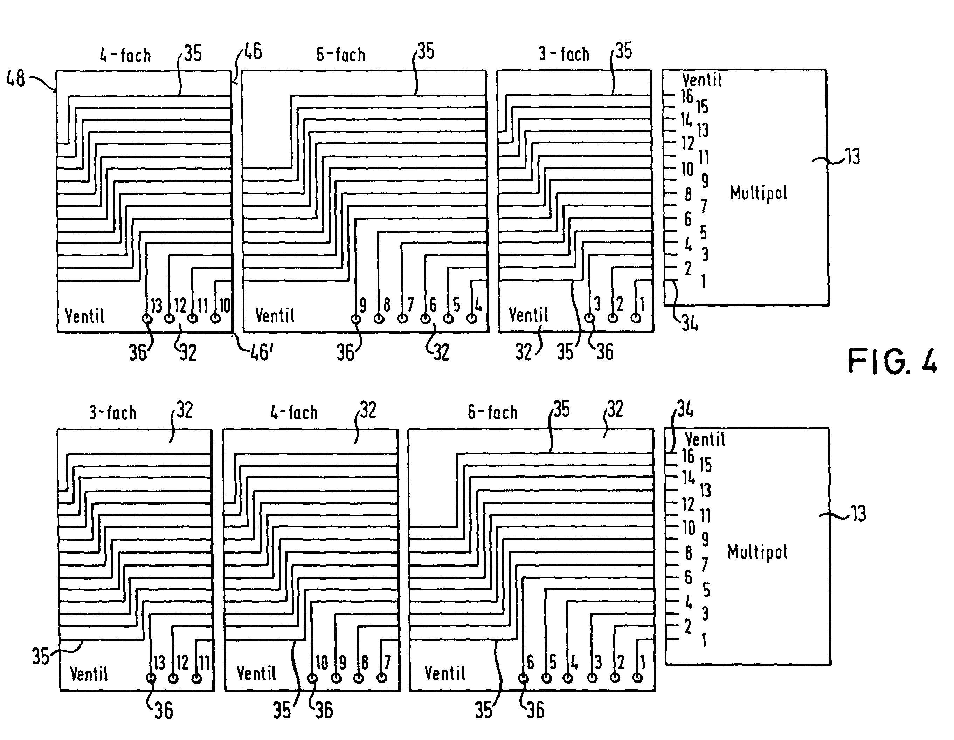

Dieser zur zentralen Versorgung und/oder Ansteuerung der dem Ventilblock zugeordneten Ventile dienende modulare elektrische Teil 10 enthält drei Grundmodule 10a, 10b, 10c. Diese Grundmodule 10a, 10b, 10c besitzen jeweils ein an zwei gegenüberliegenden Stirnseiten offenes Gehäuse 10a', 10b', 10c', in das jeweils eine Leiterplatte 32 mit wenigstens einem Anschlußkontakt 36 (vergleiche auch Fig. 4) eingesetzt ist. Bedarfsweise ist jedem Anschlußkontakt 36 jeweils ein in einer Gehäusewandung 38 vorgesehener Durchbruch 21 zugeordnet, der dem betreffenden Anschlußkontakt und einem Null-Leiterkontakt zweckmäßigerweise gegenüberliegt. Grundsätzlich können einem jeweiligen Durchbruch 21 auch mehrere Anschlußkontakte 36 mit zugeordnetem Null-Leiterkontakt gegenüberliegen, um insbesondere auch Impulsventile anschließen zu können, die zwei Anschlüsse besitzen. Ein betreffendes Ventil ist dann durch den zugeordneten Durchbruch 21 hindurch an die betreffende Anzahl von zugeordneten Anschlußkontakten 36 anschließbar.

Der linke Grundmodul 10a ist mit zwei größeren gleichen Durchbrüchen 21, der mittlere Grundmodul 10b mit vier Durchbrüchen 21 gleicher Größe und der rechte Grundmodul 10c mit sechs Durchbrüchen 21 versehen, die kleiner als die Durchbrüche der vorhergehenden Module, untereinander jedoch wiederum gleich groß sind. Diese Durchbrüche 21 dienen jeweils als Steckplatz für ein betreffendes Ventil.

Die Grundmodule 10a, 10b, 10c besitzen ferner jeweils eine LED-Anzeige 20 zur Anzeige der Funktion. Der linke Grundmodul 10a ist zudem mit Anschlüssen 19 für einen elektrischen Anschluß der Ventilantriebe an die betreffende Leiterplatte 32 versehen. Auf der Oberseite dieses Grundmoduls 10a sind ferner Öffnungen 25 vorgesehen, durch die elektrische Versorgungsleitungen herausgeführt werden können.

Dieser in den Figuren 1 bis 3 dargestellte modulare elektrische Teil 10 enthält ferner einen der zentralen Versorgung und/oder Ansteuerung dienenden Anschlußmodul 12, 13, 14 sowie wenigstens einen Blindabschlußmodul 11, 15 für die linke bzw. die rechte Seite einer jeweiligen Modulreihe.

Die Module 10a, 10b, 10c; 12, 13, 14; 11, 15 besitzen eine gleichartige Querschnittsform. Sie sind bedarfsweise unter Herstellung von jeweiligen elektrischen Zwischenverbindungen bzw. eines stirnseitigen Blindabschlusses aneinanderreihbar und lösbar miteinander verbindbar.

Bei den dargestellten Ausführungsformen können die Module jeweils über eine Schnappverbindung 22-24 lösbar miteinander verbunden werden. Diese Schnappverbindungen enthalten jeweils eine Zunge 22 mit einer Rastnase 23 und einen mit dieser Rastnase zusammenwirkenden Vorsprung 24 am benachbarten Modul. Während die für die linke Seite vorgesehenen Blindabschlußmodule 11 bei den dargestellten Ausführungsbeispielen lediglich mit Zungen 22 und Rastnasen 23 versehen sind, sind die rechten Blindabschlußelemente 15 sowie die elektrischen Anschlußelemente 12 und 13 jeweils nur mit Vorsprüngen 24 versehen.

Jeder Grundmodul 10a, 10b, 10c kann in einer noch zu beschreibenden Weise freie elektrische Ausgänge aufweisen, die über einen Anschlußmodul 12, 13, 14 versorgt und/oder angesteuert werden.

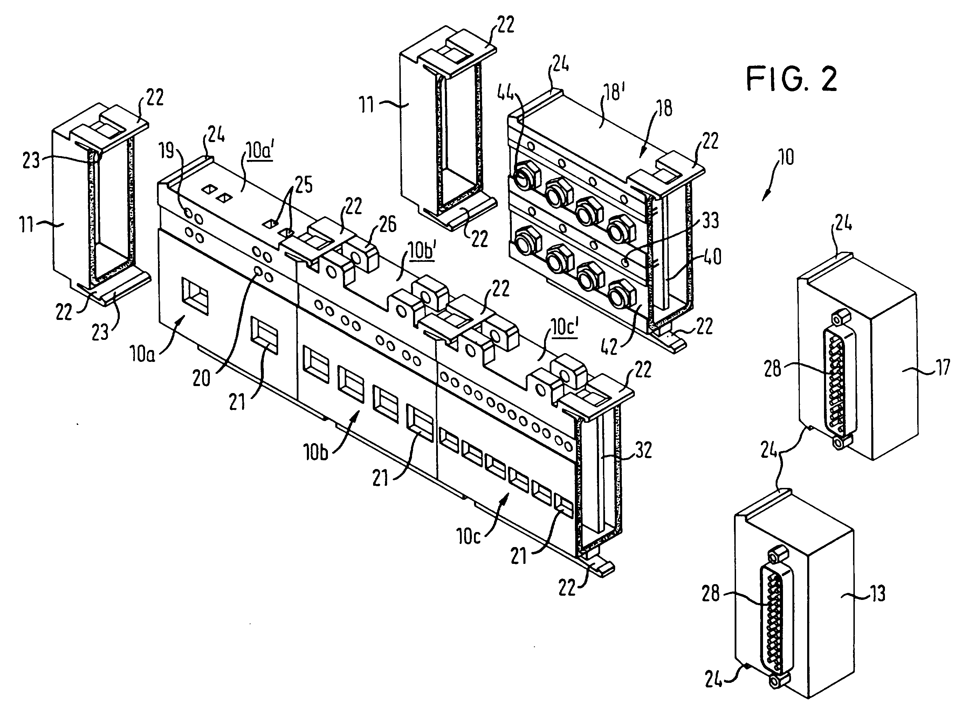

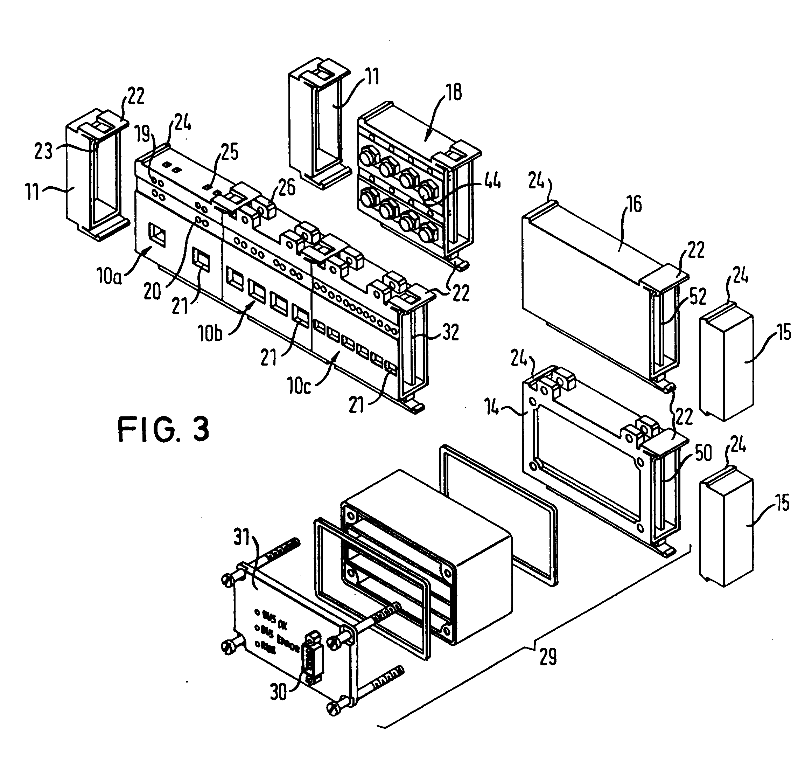

Beim in Fig. 1 dargestellten Ausführungsbeispiel ist zur elektrischen Versorgung und/oder Ansteuerung der Ventile und gegebenenfalls der freien elektrischen Ausgänge ein Null- und Schutzleiteranschlüsse 27 aufweisender Anschlußmodul 12 vorgesehen. Dagegen handelt es sich bei dem Anschlußmodul 13 der in Fig. 2 gezeigten Ausführung um einen mehrpoligen Stecker 13, der mit einem Multipol-Steckverbinder 28 versehen ist. Gemäß Fig. 3 ist zur elektrischen Versorgung und/oder Ansteuerung der Ventile und gegebenenfalls der freien elektrischen Ausgänge ein einem Feldbusmodul 29 zugeordneter Anschlußmodul 14 vorgesehen, der wiederum in der Art eines Grundmoduls eine eingesetzte Leiterplatte 50 enthalten und mit Zungen 22 und Rastnasen 23 ausgebildet sein kann, wobei dieser Anschlußmodul 14 beispielsweise durch einen Blindabschlußmodul 15 nach außen abgeschlossen werden kann. Der Feldbusmodul 29 ist mit einem Deckel 31 versehen, auf dem ein Busstecker 30 angebracht ist.

Bei den dargestellten Ausführungsbeispielen werden die zur Betätigung der Ventile erforderlichen elektrischen Signale extern angesteuert. Der jeweilige Anschlußmodul 12, 13, 14 zur elektrischen Versorgung und/oder Ansteuerung der Ventile und gegebenenfalls der freien elektrischen Ausgänge kann grundsätzlich auch eine Kleinsteuerung enthalten. Ferner ist denkbar, mehrere eine jeweilige Kleinsteuerung enthaltende Anschlußmodule anzuschließen.

Bei den in den Figuren 2 und 3 gezeigten Ausführungsformen ist ferner ein bedarfsweise auf einen jeweiligen Grundmodul 10a, 10b, 10c aufsetzbarer, über Verbindungselemente 26 lösbar mit diesem verbindbarer Rückmeldemodul 18 vorgesehen, der eine Rückmeldung von Sensorsignalen von den Ventilen ermöglicht. Zur Weiterverarbeitung dieser Signale ist der Rückmeldemodul 18 jeweils mit einem elektrischen Rückmeldeanschlußmodul 17 bzw. 16 verbindbar. Der Rückmeldeanschlußmodul 17 der in Fig. 2 gezeigten Ausführungsform ist ebenso wie der Anschlußmodul 13 wiederum als mehrpoliger Stecker mit einem Multipol-Steckverbinder 28 und Vorsprüngen 24 ausgebildet. Dagegen besitzt der in Fig. 3 gezeigte Rückmeldeanschlußmodul 16 wiederum allgemein die Form eines Grundmoduls mit einem einerseits mit Vorsprüngen 24 und andererseits mit Zungen 22 versehenen Gehäuse, in das wiederum eine Leiterplatte 52 eingesetzt ist.

Der in den Figuren 2 und 3 gezeigte Rückmeldemodul 18 besitzt nach Art eines Grundmoduls ebenfalls ein an zwei gegenüberliegenden Stirnseiten offenes Gehäuse 18', in das eine Leiterplatte 40 mit einem oder mehreren Kontakten eingesetzt ist. Die Kontakte sind jeweils mit einem in einer Gehäuseseitenwandung 42 vorgesehenen Anschluß 44 für insbesondere Sensoren verbindbar. Überdies besitzen der Rückmeldemodul 18 und der jeweilige Rückmeldeanschlußmodul 16 bzw. 17 und die zugeordneten Blindabschlußmodule 11, 15 wiederum eine gleiche Querschnittsform, so daß sie bedarfsweise unter Herstellung von jeweiligen elektrischen Zwischenverbindungen bzw. eines stirnseitigen Blindabschlusses aneinanderreihbar und über die Schnappverbindungen 22-24 durch Zusammenstecken lösbar miteinander verbindbar sind.

Die Anschlüsse 44 können durch Rundsteckeranschlüsse, Schraubklemmen oder irgend eine andere elektrische Verbindungsart gebildet sein.

Zudem besitzen der Rückmeldemodul 18 und die Rückmeldeanschlußmodule 16, 17 die gleiche Querschnittsform wie die Grundmodule 10a, 10b, 10c bzw. ein an diesen anreihbarer Anschlußmodul 12, 13, 14, wobei die einer jeweiligen Grundmodulreihe und die einer jeweiligen Rückmeldemodulreihe zugeordneten Blindabschlußmodule 11, 15 gleiqh ausgebildet und somit austauschbar sind.

Die Verbindung zwischen den vertikal übereinander angeordneten Modulen wie beispielsweise zwischen einem Grundmodul 10a, 10b, 10c und dem Rückmeldemodul 18 erfolgt zweckmäßigerweise über die Verbindungselemente 26 und nicht dargestellte Schrauben.

Während z. B. bei der in Fig. 2 dargestellten Ausführungsform die Kopplung der Ventile mit der Steuerung über den mehrpoligen Stecker 13 erfolgt, werden im Fall der in Fig. 3 gezeigten Ausführungsvariante die Ventile über den Feldbus 29 gesteuert.

Wie sich aus Fig. 4 ergibt, besitzen die den Grundmodulen 10a, 10b, 10c zugeordneten Leiterplatten 32 eine gleiche Anzahl von zumindest abschnittsweise zueinander parallelen Leiterbahnen 35, die ausgehend von dem rechten eingangsseitigen Plattenrand 46 zu dem gegenüberliegenden linken ausgangsseitigen Plattenrand 48 geführt bzw. seitlich nach unten zu Anschlußkontakten 36 abgezweigt sind. Die dem unteren Ende 46' des rechten eingangsseitigen Plattenrandes 46 am nächsten gelegenen Leiterbahnen sind beginnend mit der untersten Bahn aufeinanderfolgend in einer der Anzahl der Anschlußkontakte 36 entsprechenden Anzahl zu den Anschlußkontakten 36 geführt, während die verbleibenden Leiterbahnen am ausgangsseitigen linken Plattenrand 48 so versetzt sind, daß sie mit den dem unteren Ende 46' des eingangsseitigen Plattenrandes 46 am nächsten gelegenen Leiterbahnabschnitten ausgerichtet sind.

Die sich nach oben an die mit Anschlüssen 36 verbundenen Leiterbahnen anschließenden Bahnen dienen somit der Herstellung einer Verbindung mit den Anschlüssen 36 einer sich anschließenden Leiterplatte 32 oder als freie Anschlüsse, wie zuvor erwähnt. Somit werden die für die Anschlüsse 36 einer jeweiligen Leiterplatte 32 nicht benötigten Leiterbahnen 35 so herausgeführt, daß wiederum die unteren Leiterbahnen 35 die Verbindung zu den Anschlüssen 36 der nächsten Leiterplatte 32 herstellen. Am oberen Ende der nächsten Leiterplatte 32 bleibt stets eine solche Anzahl von Leiterbahnen 35 unkontaktiert, die durch die Anschlüsse 36 der vorhergehenden Leiterplatte 32 wegfällt. In Fig. 4 sind die zum Schließen eines jeweiligen Stromkreises erforderlichen Null-Leiterkontakte nicht dargestellt.

Um zu verdeutlichen, daß dieses Prinzip in jeder Zusammensetzung möglich ist, wurde in Fig. 4 die Reihenfolge der Leiterplatten verändert. Während in der oberen Modulreihe der Fig. 4 drei Leiterplatten 32 mit vier, sechs bzw. drei Ventilanschlüssen 36 hintereinandergeschaltet sind, sind in der unteren Modulreihe drei Leiterplatten 32 mit drei, vier bzw. sechs Anschlüssen hintereinandergeschaltet. Am rechten Ende dieser beiden Reihen ist jeweils ein als mehrpoliger Stecker ausgebildeter elektrischer Anschlußmodul 13 mit einer der Anzahl von auf den Leiterplatten vorgesehenen Leiterbahnen entsprechenden Anzahl von Anschlüssen 34 vorgesehen.

Der modulare elektrische Teil kann zweckmäßigerweise zur Verwendung in einem für die Schutzart IP 20 oder IP 65 geeigneten Ventilblock ausgelegt sein. Die Gehäuse der einzelnen Komponenten des elektrischen Teils bestehen vorzugsweise aus Kunststoff. Grundsätzlch sind jedoch auch andere geeignete Materialien denkbar.

## Patentansprüche

1. Modularer elektrischer Teil zur zentralen Versorgung und/oder Ansteuerung von einem Ventilblock zugeordneten Ventilen, dadurch gekennzeichnet, daß er wenigstens einen Grundmodul (10a, 10b, 10c) enthält, der ein an zwei gegenüberliegenden Stirnseiten offenes Gehäuse (10a', 10b', 10c') besitzt, in das eine Leiterplatte (32) mit einem oder mehreren Anschlußkontakten (36) eingesetzt ist, wobei eine Gehäuseseitenwandung (38) mit wenigstens einem Durchbruch (21) versehen ist, durch den hindurch ein betreffendes Ventil oder irgendein anderer Aktor an wenigstens einen zugeordneten Anschlußkontakt (36) anschließbar ist, und wenigstens einen der zentralen Versorgung und/oder Ansteuerung dienenden Anschlußmodul (12, 13, 14) sowie wenigstens einen Blindabschlußmodul (11, 15) enthält, und daß die Module (10a, 10b, 10c; 12, 13, 14; 11, 15) eine gleichartige Querschnittsform besitzen, bedarfsweise unter Herstellung von jeweiligen elektrischen Zwischenverbindungen bzw. eines stirnseitigen Blindabschlusses aneinanderreihbar und lösbar miteinander verbindbar sind.

2. Modularer elektrischer Teil nach Anspruch 1, dadurch gekennzeichnet, daß die Module (10a, 10b, 10c; 12, 13, 14; 11, 15) jeweils über eine Schnappverbindung (22-24) lösbar miteinander verbindbar sind.

3. Modularer elektrischer Teil nach Anspruch 1 oder 2, dadurch gekennzeichnet, daß Grundmodule (10a, 10b, 10c) mit einer unterschiedlichen Anzahl von Anschlußkontakten (36) und zugeordneten Durchbrüchen (21) vorgesehen sind.

4. Modularer elektrischer Teil nach einem der vorhergehenden Ansprüche, dadurch gekennzeichnet, daß Grundmodule (10a, 10b, 10c) mit Durchbrüchen (21) unterschiedlicher Anzahl und/oder Größe vorgesehen sind.

5. Modularer elektrischer Teil nach einem der vorhergehenden Ansprüche, dadurch gekennzeichnet, daß der Grundmodul (10a, 10b, 10c) freie elektrische Ausgänge aufweist, die über ein Anschlußmodul (12, 13, 14) versorgt und/oder angesteuert sind.

6. Modularer elektrischer Teil nach einem der vorhergehenden Ansprüche, dadurch gekennzeichnet, daß er wenigstens einen bedarfsweise auf einen jeweiligen Grundmodul (10a, 10b, 10c) aufsetzbaren, lösbar mit diesem verbindbaren Rückmeldemodul (18) enthält, der die Ventile betreffende Rückmeldesignale liefert.

7. Modularer elektrischer Teil nach Anspruch 6, dadurch gekennzeichnet, daß er wenigstens einen unter Herstellung von jeweiligen elektrischen Zwischenverbindungen bedarfsweise an den Rückmeldemodul (18) anreihbaren und lösbar mit diesem verbindbaren Rückmeldeanschlußmodul (16, 17) enthält.

8. Modularer elektrischer Teil nach einem der vorhergehenden Ansprüche, dadurch gekennzeichnet, daß zur elektrischen Versorgung und/oder Ansteuerung der Ventile und gegebenenfalls der freien elektrischen Ausgänge ein Null- und Schutzleiteranschlüsse (27) aufweisender Anschlußmodul (12) vorgesehen ist.

9. Modularer elektrischer Teil nach einem der vorhergehenden Ansprüche, dadurch gekennzeichnet, daß als Anschlußmodul zur elektrischen Versorgung und/oder Ansteuerung der Ventile und gegebenenfalls der freien elektrischen Ausgänge und/oder als Rückmeldeanschlußmodul ein mehrpoliger Stecker (13, 17) vorgesehen ist.

10. Modularer elektrischer Teil nach einem der vorhergehenden Ansprüche, dadurch gekennzeichnet, daß zur elektrischen Versorgung und/oder Ansteuerung der Ventile und gegebenenfalls der freien elektrischen Ausgänge ein einem Feldbusmodul (29) zugeordneter Anschlußmodul (14) vorgesehen ist.

11. Modularer elektrischer Teil nach einem der vorhergehenden Ansprüche, dadurch gekennzeichnet, daß der Anschlußmodul (14) zur elektrischen Versorgung und/oder Ansteuerung der Ventile und gegebenenfalls der freien elektrischen Ausgänge eine Kleinsteuerung enthält.

12. Modularer elektrischer Teil nach Anspruch 11, dadurch gekennzeichnet, daß mehrere eine jeweilige Kleinsteuerung enthaltende Anschlußmodule (14) vorgesehen sind.

13. Modularer elektrischer Teil nach einem der vorhergehenden Ansprüche, dadurch gekennzeichnet, daß ein oder mehrere Anschlußmodule (12, 13) vorgesehen sind, die Verbindungen zu externen Steuerungen bilden.

14. Modularer elektrischer Teil nach einem der vorhergehenden Ansprüche 7 bis 13, dadurch gekennzeichnet, daß der Rückmeldemodul (18) ein an zwei gegenüberliegenden Stirnseiten offenes Gehäuse (18') besitzt, in das eine Leiterplatte (40) mit einem oder mehreren Kontakten eingesetzt ist, die jeweils mit einem in einer Gehäuseseitenwandung (42) vorgesehenen Anschluß (44) verbindbar sind, und daß der Rückmeldemodul (18), der Rückmeldeanschlußmodul (16, 17) und zugeordnete Blindabschlußmodule (11, 15) eine gleiche Querschnittsform besitzen, bedarfsweise unter Herstellung von jeweiligen elektrischen Zwischenverbindungen bzw. eines stirnseitigen Blindabschlusses aneinanderreihbar und lösbar miteinander verbindbar sind.

15. Modularer elektrischer Teil nach einem der vorhergehenden Ansprüche 7 bis 14, durch gekennzeichnet, daß der Rückmeldemodul (18) und der Rückmeldeanschlußmodul (16, 17) die gleiche Querschnittsform wie der Grundmodul (10a, 10b, 10c) bzw. ein an diesen anreihbarer Anschlußmodul (13, 14) besitzen und daß zumindest die einer jeweiligen Grundmodulreihe und die einer jeweiligen Rückmeldemodulreihe zugeordneten Blindabschlußmodule (11, 15) gleich ausgebildet und somit austauschbar sind.

16. Modularer elektrischer Teil nach einem der vorhergehenden Ansprüche, dadurch gekennzeichnet, daß einem Durchbruch (21) jeweils wenigstens ein Anschlußkontakt (36) und ein Null-Leiterkontakt gegenüberliegt.

17. Modularer elektrischer Teil nach einem der Ansprüche 1 bis 15, dadurch gekennzeichnet, daß einem Durchbruch (21) für den Anschluß eines Impulsventils oder dergleichen jeweils wenigstens zwei Anschlußkontakte (36) gegenüberliegen.

18. Modularer elektrischer Teil nach einem der vorhergehenden Ansprüche, dadurch gekennzeichnet, daß die den Grundmodulen (10a, 10b, 10c) und/oder Rückmeldemodulen (18) zugeordneten Leiterplatten (32, 40) eine gleiche Anzahl von zumindest abschnittsweise zueinander parallelen Leiterbahnen (35) aufweisen, die ausgehend von einem eingangsseitigen Plattenrand (46) zu dem gegenüberliegenden ausgangsseitigen Plattenrand (48) geführt bzw. seitlich zu Anschlußkontakten (36) abgezweigt sind, wobei die einem Ende (46') des eingangseitigen Plattenrandes (46) am nächsten gelegenen Leiterbahnen beginnend mit der dem Ende (46') benachbarten Bahn aufeinanderfolgend in einer der Anzahl der Anschlußkontakte (36) entsprechenden Anzahl zu den Anschlußkontakten (36) geführt sind, während die verbleibenden Leiterbahnen am ausgangsseitigen Plattenrand (48) so versetzt sind, daß sie mit den dem einen Ende (46') des eingangseitigen Plattenrandes (46) am nächsten gelegenen Leiterbahnabschnitten ausgerichtet sind.

19. Modularer elektrischer Teil nach einem der vorhergehenden Ansprüche, dadurch gekennzeichnet, daß er einem für die Schutzart IP 20 ausgelegten Ventilblock zugeordnet ist.

20. Modularer elektrischer Teil nach einem der vorhergehenden Ansprüche, dadurch gekennzeichnet, daß er einem für die Schutzart IP 65 ausgelegten Ventilblock zugeordnet ist.

## Claims

1. A modular electric part for the central power supply and/or signal-control of valves assigned to a valve block, characterized in that the modular electric part includes at least one base module (10a, 10b, 10c) having a housing (10a', 10b', 10c') open at two opposed ends and into which a circuit board (32) having one or more terminal contacts (36) is inserted, one housing sidewall (38) being provided with at least one knockout (21), through which a corresponding valve or some other actor is connectable to at least one assigned terminal contact (36), and further includes at least one connecting module (12, 13, 14) serving the central power supply and/or signal-control, as well as at least one blanking module (11, 15), and in that the modules (10a, 10b, 10c; 12, 13, 14; 11, 15) have an identical cross-sectional shape and are able to be releasably connected to each other in-line, where necessary by producing respective electrical interconnections or an end blanking.

2. The modular electric part as set forth in claim 1, characterized in that each of the modules (10a, 10b, 10c; 12, 13, 14; 11, 15) is able to be releasably connected to each other via a snap-action connector (22-24).

3. The modular electric part as set forth in claim 1 or 2, characterized in that base modules (10a, 10b, 10c) having different numbers of terminal contacts (36) and assigned knockouts (21) are provided.

4. The modular electric part as set forth in any of the preceding claims, characterized in that base modules (10a, 10b, 10c) having knockouts (21) which differ in number and/or size are provided.

5. The modular electric part as set forth in any of the preceding claims, characterized in that the base module (10a, 10b, 10c) comprises free electrical outputs which are power-supplied and/or signal-controlled via a connecting module (12, 13, 14).

6. The modular electric part as set forth in any of the preceding claims, characterized by it including at least one feedback module (18) which is mountable, where necessary, on a respective base module (10a, 10b, 10c) and adapted to be releasably connected thereto, and which furnishes the feedback signals relating to the valves.

7. The modular electric part as set forth in claim 6, characterized by it including at least one feedback connecting module (16, 17) for in-line mounting to the feedback module (18) and releasably connectable thereto by producing respective electrical interconnections as required.

8. The modular electric part as set forth in any of the preceding claims, characterized in that for the electrical power supply and/or signal-control of the valves and, where necessary, of the free electrical outputs, a connecting module (12) comprising zero and neutral lead connections (27) is provided.

9. The modular electric part as set forth in any of the preceding claims, characterized in that a multipin connector (13, 17) is provided as connecting module for the electrical power supply and/or signal-control of the valves and, where necessary, of the free electrical outputs and/or as feedback connecting module.

10. The modular electric part as set forth in any of the preceding claims, characterized in that a connecting module (14) assigned to a field bus module (29) is provided for the electrical power supply and/or signal-control of the valves and, where necessary, of the free electrical outputs.

11. The modular electric part as set forth in any of the preceding claims, characterized in that the connecting module (14) for the electrical power supply and/or signal-control of the valves and, where necessary, the free electrical outputs includes a small-signal-control.

12. The modular electric part as set forth in claim 11, characterized in that a plurality of connecting modules (14) is provided, each including a small-signal-control.

13. The modular electric part as set forth in any of the preceding claims, characterized in that one or more connecting modules (12, 13) are provided, forming connections to external controls.

14. The modular electric part as set forth in any of the preceding claims 7 to 13, characterized in that the feedback module (18) has a housing (18') open at two opposed ends and into which a circuit board (40) having one or more contacts is inserted, each of which is connectable to a terminal (44) provided in a housing sidewall (42), and in that the feedback module (18), the feedback connecting module (16, 17) and assigned blanking modules (11, 15) have an identical cross-sectional shape and are able to be releasably connected to each other in-line, where necessary by producing respective electrical interconnections or an end blanking.

15. The modular electric part as set forth in any of the preceding claims 7 to 14, characterized in that the feedback module (18) and the feedback connecting module (16, 17) have the same cross-sectional shape as the base module (10a, 10b, 10c) or a connecting module (13, 14) for in-line mounting to the latter, and in that at least the blanking modules (11, 15) assigned to a respective row of base modules and to a respective row of feedback modules are configured identical and thus interchangeable.

16. The modular electric part as set forth in any of the preceding claims, characterized in that at least one terminal contact (36) and one zero lead contact face each knockout (21).

17. The modular electric part as set forth in any of claims 1 to 15, characterized in that at least two terminal contacts (36) face each knockout (21) for connecting a pulsed valve or the like.

18. The modular electric part as set forth in any of the preceding claims, characterized in that the circuit boards (32, 40) assigned to the base modules (10a, 10b, 10c) and/or the feedback modules (18) have the same number of conductor paths (35) parallel to each other at least sectionwise which starting from a board edge (46) at the input end are guided to the opposite board edge (48) at the output end or are branched off on the side to terminal contacts (36), the conductor paths located nearest to one end (46') of the input end board edge (46) being guided to the terminal contacts (36), beginning with the path adjacent to the end (46'), in sequence in a number corresponding to the number of terminal contacts (36)), whilst the remaining conductor paths at the output end board edge (48) are staggered in such a way that they are oriented with respect to the conductor path sections located nearest to the one end (46') of the board edge (46) at the input end.

19. The modular electric part as set forth in any of the preceding claims, characterized by it being assigned to a valve block designed for enclosure code IP 20.

20. The modular electric part as set forth in any of the preceding claims, characterized by it being assigned to a valve block designed for enclosure code IP 65.

## Revendications

1. Pièce électrique modulaire destinée à l'alimentation et/ou la commande centrales d'électrovannes associées à un bloc d'électrovannes, caractérisée en ce que ladite pièce comprend au moins un module de base (10a, 10b, 10c), qui comporte un boîtier (10a', 10b', 10c') ouvert sur les deux faces frontales opposées, dans lequel est insérée une plaquette de circuits imprimés (32) munie d'un ou plusieurs contacts de connexion (36), une paroi latérale du boîtier (38) étant munie d'au moins un passage (21), à travers lequel une électrovanne concernée ou n'importe quel autre actionneur peuvent être connectés avec au moins un contact de connexion (36) associé, et comprend au moins un module de connexion (12, 13, 14) utilisé pour l'alimentation et/ou la commande centrales, ainsi qu'au moins un module de connexion réactive (11, 15), et en ce que les modules (10a, 10b, 10c ; 12, 13, 14 ; 11, 15) présentent une section de même forme, ils peuvent être assemblés les uns avec les autres et les uns à côté des autres, de manière amovible en formant si nécessaire des liaisons électriques intermédiaires avec chacun d'entre eux et une obturation aveugle sur la face frontale.

2. Pièce électrique modulaire selon la revendication 1, caractérisée en ce que les modules (10a, 10b, 10c ; 12, 13, 14 ; 11, 15) peuvent être assemblés les uns avec les autres de manière amovible par un assemblage par emboîtement.

3. Pièce électrique modulaire selon la revendication 1 ou 2, caractérisée en ce qu'il est prévu des modules de base (10a, 10b, 10c) avec un nombre différent de contacts de connexion (36) et de passages (21) associés.

4. Pièce électrique modulaire selon l'une quelconque des revendications précédentes, caractérisée en ce qu'il est prévu des modules de base (10a, 10b, 10c) avec des passages (21) en nombre différent et/ou de taille différente.

5. Pièce électrique modulaire selon l'une quelconque des revendications précédentes, caractérisée en ce que le module de base (10a, 10b, 10c) comporte des sorties électriques libres, qui sont alimentées et/ou commandées par l'intermédiaire d'un module de connexion (12, 13, 14).

6. Pièce électrique modulaire selon l'une quelconque des revendications précédentes, caractérisée en ce que ladite pièce comprend au moins un module pour signal de retour (18) qui, si nécessaire, peut être monté sur un module de base (10a, 10b, 10c) respectif et peut être assemblé de manière amovible avec celui-ci, et qui fournit les signaux de retour concernant les électrovannes.

7. Pièce électrique modulaire selon la revendication 1, caractérisée en ce que ladite pièce comprend au moins un module de connexion pour signal de retour (16, 17) qui peut être juxtaposé si nécessaire au module pour signal de retour (18) en formant des liaisons électriques intermédiaires respectives et qui peut être assemblé de manière amovible avec celui-ci.

8. Pièce électrique modulaire selon l'une quelconque des revendications précédentes, caractérisée en ce qu'il est prévu pour l'alimentation et/ou la commande électrique des électrovannes et, le cas échéant, des sorties électriques libres un module de connexion (12) comportant des connexions pour fil pilote et fil de terre (27).

9. Pièce électrique modulaire selon l'une quelconque des revendications précédentes, caractérisée en ce qu'il est prévu une prise (13, 17) à plusieurs broches pour former le module de connexion, destiné à l'alimentation et/ou la commande électrique des électrovannes et, le cas échéant, des sorties électriques libres, et/ou pour former le module de connexion pour signal de retour.

10. Pièce électrique modulaire selon l'une quelconque des revendications précédentes, caractérisée en ce que, pour l'alimentation et/ou la commande électrique des électrovannes et, le cas échéant, des sorties électriques libres, il est prévu un module de connexion (14) associé à un module de bus de champ (29).

11. Pièce électrique modulaire selon l'une quelconque des revendications précédentes, caractérisée en ce que le module de connexion (14) destiné à l'alimentation et/ou la commande électrique des électrovannes et, le cas échéant, des sorties électriques libres, comporte une commande miniature.

12. Pièce électrique modulaire selon la revendication 11, caractérisée en ce qu'il est prévu plusieurs modules de connexion (14) contenant chacune une commande miniature.

13. Pièce électrique modulaire selon l'une quelconque des revendications précédentes, caractérisée en ce qu'il est prévu un ou plusieurs modules de connexion (12, 13), qui forment des liaisons avec des commandes externes.

14. Pièce électrique modulaire selon l'une quelconque des revendications 7 à 13, caractérisée en ce que le module pour signal de retour (18) comprend un boîtier (18') ouvert sur les deux faces frontales opposées, dans lequel est insérée une plaquette de circuits imprimés (40) munie d'un ou plusieurs contacts de connexion, qui peuvent être connectés chacun avec une connexion (44) prévue dans une paroi latérale du boîtier (42), et en ce que le module pour signal de retour (18), le module de connexion pour signal de retour (16, 17) et des modules de connexion réactive (11, 15) associés présentent une section de même forme et peuvent être assemblés les uns avec les autres, les uns à côté des autres de manière amovible en formant si nécessaire des liaisons électriques intermédiaires avec chacun d'entre eux et une obturation aveugle sur la face frontale.

15. Pièce électrique modulaire selon l'une quelconque des revendications 7 à 14, caractérisée en ce que le module pour signal de retour (18) et le module de connexion pour signal de retour (16, 17) présentent la même forme de section que le module de base (10a, 10b, 10c) ou possèdent un module de connexion (13, 14) qui peut être juxtaposé à celui-ci et en ce qu'au moins les modules d'obturation aveugle (11, 15) appartenant à une rangée respective de modules de base et associés à une rangée respective de modules pour signal de retour (11, 15) sont conçus de manière identique et peuvent donc être permutés.

16. Pièce électrique modulaire selon l'une quelconque des revendications précédentes, caractérisée en ce qu'en face de chaque passage (21) est disposé au moins un contact de connexion (36) et un contact pour fil de terre.

17. Pièce électrique modulaire selon l'une quelconque des revendications 1 à 15, caractérisée en ce qu'au moins deux contacts de connexion (36) sont disposés en face de chaque passage (21) destiné à la connexion d'une électrovanne à impulsions ou un élément analogue.

18. Pièce électrique modulaire selon l'une quelconque des revendications précédentes, caractérisée en ce que les plaquettes de circuits imprimés (32, 40) associées aux modules de base (10a, 10b, 10c) et/ou aux modules pour signal de retour (18) comportent le même nombre de pistes conductrices (35) parallèles au moins par sections, qui sont guidées à partir d'un bord de la plaquette (46) du côté de l'entrée vers un bord opposé (48) de la plaquette du côté de la sortie ou sont déviées latéralement vers les contacts de connexion (36), les pistes conductrices situées le plus près d'une extrémité (46') du bord de la plaquette (46) du côté de l'entrée étant guidées successivement vers les contacts de connexion (36), en commençant par la piste contiguë à l'extrémité (46') selon un nombre de contacts de connexion (36) correspondant au nombre de contacts de connexion (36), alors que les pistes conductrices restantes sur le bord de la plaquette (48) du côté de la sortie sont décalées de telle sorte qu'elles sont alignées avec les sections de pistes conductrices les plus proches de l'une des extrémités (46') du bord de la plaquette (46) du côté de l'entrée.

19. Pièce électrique modulaire selon l'une quelconque des revendications précédentes, caractérisée en ce que ladite pièce est associée à un bloc d'électrovannes conçu pour le type de protection IP 20.

20. Pièce électrique modulaire selon l'une quelconque des revendications précédentes, caractérisée en ce que ladite pièce est associée à un bloc d'électrovannes conçu pour le type de protection IP 65.
